# EUROPÄISCHE PATENTANMELDUNG

(11) **EP 0 554 798 A2**
(43) Veröffentlichungstag der Anmeldung: **11.08.1993**
(21) Anmeldenummer: 93101357.7
(22) Anmeldetag: 29.01.1993
(51) Int. Cl.: H01B 1/12, C08G 61/12, C09D 5/24, B44C 1/14, C23C 14/02, C23C 14/00

(54) **Beschichtungsmittel für Kunststofffolien**

(30) Priorität: 05.02.1992 DE 4203208 U
(71) Anmelder: HOECHST AKTIENGESELLSCHAFT, D-65926 Frankfurt am Main (DE)
(72) Erfinder: Beer, Ekkehard, W-6208 Bad Schwalbach (DE); Kochem, Karl-Heinz Dr., W-6530 Bingen-Dietersheim (DE); Schmidt, Michael, W-6227 Oestrich-Winkel (DE)

(57) **Zusammenfassung**

Es wird ein Beschichtungsmittel für Kunststoffolien beschrieben, enthaltend ein intrinsisch elektrisch leitfähiges Polymer und ein oder mehrere Additive, welche gegenüber einer auf die Kunststoffolie aufzubringenden Metallschicht eine Antihaftwirkung besitzen und ein Verfahren zur Beschichtung dieser Kunststoffolien, sowie die so beschichteten Kunststoffolien.

## Beschreibung

Die Erfindung betrifft ein Beschichtungsmittel für Kunststoffolien, die so beschichteten Kunststoffolien und deren Verwendung, insbesondere bei der Transfermetallisierung.

Bei der Transfermetallisierung werden dünne Metallschichten von einer Kunststoffträgerfolie auf ein zu metallisierendes Substrat - beispielsweise ein Papier - übertragen. Hierbei geht man gewöhnlich so vor, daß man zunächst eine Kunststoffolie, beispielsweise eine Polypropylenfolie oder eine Polyesterfolie, mit einer dünnen Metallschicht beschichtet. Hierzu bedient man sich üblicherweise der Vakuummetallisierungstechnik. Nach der Metallisierung der Kunststoftträgerfolie wird diese mit dem zu metallisierenden Substrat kontaktiert, wobei man dafür Sorge trägt, daß die Haftung zwischen (zu metallisierendem) Substrat und der Metallschicht größer ist als zwischen Metallschicht und Kunststoffträgerfolie. Dies geschieht üblicherweise durch einen Kleber, den man entweder auf das (zu metallisierende) Substrat oder auf die Metallschicht aufträgt. Nach der Kontaktierung von Substrat und metallisierter Trägerfolie und gegebenenfalls nach dem Aushärten des Klebers werden Substrat und Trägerfolie wieder getrennt, wobei die Metallschicht auf dem Substrat verbleibt. Die Kunststoffträgerfolie kann nun erneut metallisiert werden und für einen weiteren Transfermetallisierungsprozeß eingesetzt werden. Je nach Art und Beschaffenheit der Trägerfolie kann dieser Vorgang mehrfach wiederholt werden.

Sowohl das Transfermetallisierungsverfahren selbst als auch geeignete Trägerfolien sind bekannt und im Stand der Technik beschrieben (EP-A-0 175 259, EP-A-0 208 257, EP-A-0 216 342, EP-A-0 266 650, DE-A-25 55 087, DE-A-28 56 510, DE-A-29 07 186, DE-A-27 47 241 und US-A-4,153,495).

Diese bekannten Trägerfolien sind jedoch mit den verschiedensten Nachteilen behaftet. So weisen beispielsweise Polyesterfolien von sich aus eine so große Haftung zu der Metallschicht auf, daß die zu metallisierende Oberfläche dieser Polyesterfolie mit einem haftungsreduzierenden Mittel (Trennlack) versehen werden muß, um überhaupt eine Übertragung der Metallschicht auf ein anderes Medium zu ermöglichen. Bei einer Mehrfachverwendung dieser Trägerfolie muß die erneut zu metallisierende Oberfläche immer wieder mit dem haftungsreduzierenden Mittel bestrichen werden. Aus verfahrenstechnischen Gründen kommt es hierbei in den Randbereichen der Trägerfolie zu Unregelmäßigkeiten in der Beschichtung und damit zu unkontrollierbaren Schwankungen in der Metallhaftung. Aus diesem Grund muß eine solche Trägerfolie nach jeder Metallisierung besäumt werden, was zu immer schmaleren Trägerfolien führt und somit letztendlich die Anzahl der Wiederverwertungen einer solchen Folie beschränkt. Außerdem ist es für Transfermetallisieranwender unwirtschaftlich, wenn die Breite des zu metallisierenden Substrats jedesmal der variierenden Breite der Trägerfolie angepaßt werden muß.

Ein weiterer Nachteil ist in der notwendigen doppelseitigen Metallisierung der Trägerfolie zu sehen; d.h. gewöhnlich wird auf der Trägerfolie nicht nur die zu transferierende Metallschicht aufgebracht, sondern außerdem - auf die Rückseite der Trägerfolie - eine zweite, permanente Metallschicht, die dazu dient, elektrostatische Aufladungen, die bei der Herstellung und insbesondere beim Abwickeln der Folien entstehen, abzuführen. [Die Ladung bildet sich erst dann aus, wenn man zwei (unterschiedliche) Kunststoffe aneinander vorbei bewegt.]

Erfolgt keine elektrische Entladung, bilden sich im Transferschritt auf der metallisierten Oberfläche sogenannte Lichtenbergsche Figuren ab. Je nach Intensität der vorhandenen elektrostatischen Aufladung können dies nicht nur optische Defekte sein. Auch kann die Haftung der zu transferierenden Schichten auf der Kunststoffbahn derart erhöht werden, daß eine Delaminierung später nicht mehr möglich ist. Dies führt dann im Delaminierungsprozeß zu Abrissen und gegebenenfalls Beschädigungen der Einrichtungen.

Die Verwendung von Polyolefinfolien bringt darüber hinaus eine Beschränkung der Verarbeitungstemperatur mit sich. Hieraus resultiert, daß mit großen Verweilzeiten (langen Trockenkanälen) und einer Querkontraktion der Folienbahnen durch die Zugkräfte gerechnet werden muß, wenn die Temperaturen materialspezifisch zu hoch liegen.

Weiterhin ist ein Trägermaterial gesucht, welches beim Aushärten der Zweikomponentenkleber im Elektronstrahlprozeß eine höhere Resistenz aufweist als das am häufigsten eingesetzte Polypropylen.

Es bestand dementsprechend die Aufgabe, eine Trägerfolie für Transfermetallisieranwendungen zur Verfügung zu stellen, die die obengenannten Nachteile, die mit Trägerfolien gemäß Stand der Technik verbunden sind, vermeidet. Die Trägerfolie soll insbesondere eine ausgewogene Haftung zur Metallschicht aufweisen, mehrfach wiederverwendbar sein und die Entstehung von Blitzfiguren vermeiden.

Diese Aufgabe wird gelöst durch ein Beschichtungsmittel für Kunststoffolien, enthaltend ein intrinsisch elektrisch leitfähiges Polymer und ein oder mehrere Additive, welche gegenüber einer auf die Kunststoffolie aufzubringenden Metallschicht eine Antihaftwirkung besitzen.

Die Aufgabe wird weiterhin gelöst durch ein Verfahren zur Beschichtung einer Kunststoffolie, wobei die Kunststoffolie mit dem erfindungsgemäßen Beschichtungsmittel beschichtet wird.

Weiterhin betrifft die Erfindung die Verwendung des Beschichtungsmittels für Kunststoffolien für die Transfermetallisierung.

Schließlich betrifft die Erfindung die mittels des erfindungsgemäßen Beschichtungsmittels und des erfindungsgemäßen Verfahrens erhältlichen metallisierten Kunststoffolien.

Intrinsisch elektrisch leitfähige Polymere wie Polypyrrole, Polythiophene oder Polyaniline sind bekannt. Polyalkoxythiophene werden beispielsweise in der DE-A-37 17 668 oder in der EP-A-0 257 573 beschrieben. In diesen Schritten ist auch bereits erwähnt, daß sich solche intrinsisch elektrisch leitfähige Polymere als antistatische Beschichtungen für Kunststoffolien eignen. Bei Versuchen, die solchermaßen antistatisch beschichtete Folie in einem Transfermetallisierungsprozeß einzusetzen, wurde jedoch festgestellt, daß eine Übertragung der Metallschicht auf andere Substrate nur bei gleichzeitiger Ablösung der antistatischen Beschichtung vom Substrat möglich war. Oder aber die Haftung der Antistatikschicht zur Metallschicht und zur beschichteten Kunststoffolie war so gut, daß eine Übertragung auf andere Substrate generell nicht möglich war. Es mußte deshalb angenommen werden, daß solchermaßen antistatisch ausgerüstete Kunststoffolien nicht für den Transfermetallisierungsprozeß geeignet sind.

Überraschenderweise wurde nun gefunden, daß durch die Einarbeitung eines Antihaftmittels in das Beschichtungsmittel für die Kunststoffolien die Haftung zu der aufzubringenden Metallschicht so weit reduziert werden konnte, daß sich die Metallschicht problemlos transferieren ließ, ohne dabei die Haftung der antistatischen Beschichtung an der Oberfläche der Kunststoffolie so weit zu reduzieren, daß sich diese bei dem Transferprozeß ebenfalls merklich ablöste.

Die erfindungsgemäße Beschichtung enthält die intrinsisch elektrisch leitfähigen Polymere, insbesondere Polyalkoxythiophene in einer Menge von 5 bis 90 Gew.-%, bevorzugt 10 bis 50 Gew.-%, bezogen auf das Trockengewicht des Beschichtungsmittels. Das oder die Additive mit der Antihaftwirkung auf die Metallschicht ist in dem Beschichtungsmittel (bezogen auf das Trockengewicht des Beschichtungsmittels) in einer Menge von 1 bis 85 Gew.-%, bevorzugt 5 bis 75 Gew.-%, enthalten. Die Summe beider Bestandteile übersteigt niemals 100 Gew.-%. Für die Beschichtung von Kunststoffolien ist es zweckmäßig, die genannten Komponenten in einem oder mehreren Lösemitteln zu lösen, zu quellen oder zu dispergieren. Der Feststoffgehalt des Beschichtungsmittels beträgt 1 bis 20 Gew.-%, bezogen auf das Gewicht des einsatzfertigen Beschichtungsmittels.

Zur Verbesserung der Haftung der Beschichtung auf der Oberfläche der Kunststoffolie hat es sich als günstig erwiesen, wenn man zusätzlich zu den obengenannten Bestandteilen des Beschichtungsmittels in dieses noch ein Bindemittel einarbeitet. Dies ist jedoch nicht zwingend erforderlich. Dementsprechend beträgt der Gehalt an diesen Bindemittels 0 bis 90 Gew.-%, vorzugsweise 5 bis 75 Gew.-%, bezogen auf das Trockengewicht des Beschichtungsmittels. Auch hierbei übersteigt die Summe aller Bestandteile niemals 100 Gew.-%.

Als Kunststoff(träger)folie eignen sich die üblicherweise für die Transfermetallisierung eingesetzten Folien, beispielsweise Polyesterfolien, insbesondere Polyethylenterephthalatfolien, aber auch Folien auf Basis von α-Olefinen wie Polypropylenfolien. Diese Folien können ein- oder mehrschichtig sein.

Die für die Beschichtung verwendeten intrinsisch elektrisch leitfähigen Polymere sind insbesondere Polypyrrole, Polythiophene und Polyaniline. Bevorzugt werden Polyalkoxythiophene eingesetzt, wie sie in der EP-A-0 257 573 beschrieben sind, auf die an dieser Stelle ausdrücklich Bezug genommen wird. Aus dieser Anmeldung sind intrinsisch elektrisch leitfähige Polyalkoxythiophene, vorzugsweise Oligomere, bekannt, die elektrochemisch synthetisiert und in der oxidierten Form in dipolar aprotischen Lösemitteln bei Raumtemperatur vollständig löslich sind und die sich aus Struktureinheiten der Formel (I) 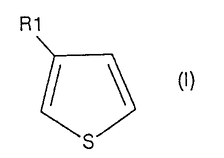
zusammensetzen, wobei R¹ eine C₁- bis C₁₂-, vorzugsweise C₁ bis C₄-Alkoxygruppe bedeutet. Die Monomereinheiten sind in 2-Stellung und/oder 5-Stellung miteinander verbunden.

Die elektrisch leitfähigen Polymeren enthalten in ihrer oxidierten Form zur Kompensation der positiven Ladungen auf der Polymerkette eine entsprechende Anzahl von Anionen, vorzugsweise Anionen des Leitsalzes, das bei dem Elektrolyseherstellverfahren eingesetzt wird. Beispiele sind: BF₄⁻, PF₆⁻- SbF₆⁻, SbCl₆⁻, FeCl₄⁻, [Fe(CN₆)]³⁻ usw.

Beispiele geeigneter Bindemittel, die eine ausreichende Haftung auf verschiedenen Kunststoffolien, insbesondere auch auf Polyesterfolien, gewährleisten und die gegenüber den leitfähigen (oxidierten) Polyalkoxythiophenen ein chemisch inertes Verhalten aufzeigen, also beispielsweise nicht oxidierend oder reduzierend wirken, sind in der DE-A-37 17 668 beschrieben. Geeignete Bindemittel sind Polyvinylacetal, Polyvinylacetat, Polyacrylat, Polymaleinsäureanhydrid, Poly-N-vinylpyrrolidon, Polypropylenoxid, Celluloseacetat, Styrol-Acrylnitril-Copolymere, Polyacrylnitril, Polymethacrylnitril, Polyvinylchlorid, Polyvinylidenfluorid, Poly-N-vinylcarbazol, Poly-N-vinylacetamid, Polyacrylsäureanhydrid, Polyethylencarbonat, Polycarbonat, Polymethylmethacrylat, Polyethylmethacrylat, Polyethylenoxid, Polyester, Polyethylen, Polypropylen oder generell Polyolefine, Poly-ε-caprolactam, Polyurethan, Polyvinylalkohol sowie beliebige Copolymere hieraus. Bevorzugt sind Polymethylmethacrylat, Polyvinylacetat und Polyester sowie beliebige Copolymere hieraus.

Erfindungsgemäße Additive sind solche Materialien, die gewöhnlich eine geringe Haftung gegenüber Metallen, insbesondere gegenüber Aluminium, aufweisen. Dazu zählen vorzugsweise sogenannte Trennharze aus fluorhaltigen und/oder fluormodifizierten Polymeren, Silikonharze, Silikonöle, Polysiloxane sowie übliche Trenn- und Gleitmittel, wie zum Beispiel Fettsäuren und deren Metallsalze, Alkylamine, Fettsäureester, -amide und Sulfonate. Diese Materialien sind dadurch gekennzeichnet, daß sie eine - im Gegensatz zu Materialien, die eine gute Haftung zu Metallschichten aufweisen - geringe Oberflächenspannung von unterhalb 30 dyn/cm, vorzugsweise unterhalb 25 dyn/cm, aufweisen.

Zur Herstellung der Beschichtungsrezeptur wird das elektrisch leitfähige Polymer, insbesondere das Polyalkoxythiophen, zunächst in einem geeigneten Lösemittel gelöst beziehungsweise dispergiert. Als Lösemittel kommen nach der EP-A-0 257 573 für Polyalkoxythiophen dipolar aprotische Lösemittel oder Lösemittelgemische in Frage. Beispiele hierfür sind Acetonitril, N-Methylpyrrolidon und N,N-Dimethylformamid. In anderen Lösemitteln kann das verwendete leitfähige Polymer zwar nicht gelöst, jedoch eventuell dispergiert werden. Dazu zählen vorzugsweise Aceton, Methylenchlorid, Tetrahydrofuran, Ethanol und Wasser. Die zusätzlich verwendeten Bindemittel und Additive werden ebenfalls bevorzugt im gleichen Lösemittel oder einem anderen der oben beschriebenen Lösemittel gelöst und/oder dispergiert.

Anschließend werden die beiden Ansätze (1. gelöstes leitfähiges Polymer; 2. gelöste Bindemittel und Additive) miteinander vermischt. Diese geschieht vorzugsweise bei maximal 80 °C, insbesondere bei 20 bis 40 °C.

Die Beschichtung der Kunststoffolien erfolgt dann mittels konventioneller Naßfilmbeschichtungsverfahren mit anschließender Trocknung mittels Heißluft und/oder Wärmestrahlen.

Bevorzugte Verfahren für das Aufbringen der Beschichtung sind der Tiefdruck, der Flexodruck, der Glattwalzenantrag sowie Tauch- und Sprühverfahren.

Die Dicke der angetragenen getrockneten Schicht liegt zwischen 10 nm und 1 µm, vorzugsweise zwischen 100 und 300 nm. Verwendet man zur Beschichtung leitfähige Polyalkoxythiophene, so haben diese in Lösung ein Absorptionsmaximum zwischen 450 und 650 nm. Daher ist die Farbe der Beschichtung in Durchsicht blau bis blau-violett, falls die übrigen verwendeten Bindemittel und Additive selbst farblos sind.

Der Oberflächenwiderstand der beschichteten Polyesterfolie beträgt - abhängig vom relativen Anteil des leitfähigen Polymers in der Schicht und von der Schichtdicke - 10⁵ bis 10¹¹ Ohm, vorzugsweise 10⁶ bis 10⁹ Ohm. Die Schichten zeigen eine gute Haftung zur Kunststoffolienoberfläche und gleichzeitig eine geringe Haftung gegenüber im Vakuum aufgebrachten Metallschichten. Ein mehrmaliges Ablösen von Metallschichten mit Hilfe eines Tesafilmbandes (Gitterschnitt) gelingt vollständig und ohne wesentliche Beeinträchtigung der Schichteigenschaften, insbesondere ohne nennenswerte Abnahme des Oberflächenwiderstandes. Von besonderer Bedeutung ist darüber hinaus, daß der Oberflächenwiderstand der Beschichtung, verursacht durch die intrinsische Stabilität des elektrisch leitfähigen Polymers, nicht von der umgebenden Luftfeuchte abhängig ist und daher unter Hochvakuumbedingungen unverändert bleibt. Überraschenderweise hat sich darüber hinaus noch gezeigt, daß sich das erfindungsgemäße Beschichtungsmittel auch als Beschichtung für prägbare Folien eignet. Auch diese Folien werden häufig verwendet, um Metallschichten auf andere Substrate zu übertragen.

Im Folgenden wird die Erfindung anhand von Beispielen näher erläutert.

### Beispiel 1

In 47.9g NMP(N-methyl-pyrrolidon/Lösemittel mit einem Reinheitsgrad von 99.5 %) wurden zunächst 0.5g elektrisch leitfähiges Polyethoxythiophen (beschrieben in EP-A-0 257 573; spezifische Leitfähigkeit 1.19 S/cm) und 1.4 g Dynapol L 206 (löslicher Copolyester der Fa. Hüls AG) bei Raumtemperatur gelöst. Anschließend wurden 0.1 g Edaplan LA411 (Verlaufmittel auf Silikonbasis der Fa. Münzing-Chemie GmbH) und 0.1 g Ceridust 9205F ((PTFE)-Micropulver der Fa. Hoechst AG mit einem mittleren Korndurchmessern von 8 µm, Dichte 2,2 g/cm³) unter ständigem Umrühren hinzugegeben.

Der Ansatz wurde dann ca. 4 Stunden auf einem Laborhorizontalschüttler bei 280 Zyklen/min geschüttelt.

Der Ansatz hatte einen Feststoffgehalt von 4 % bei einem Mengenverhältnis Polyethoxythiophen: Dynapol L 206 : Ceridust T 9205F von 25:70:5. Sämtliche Feststoffkomponenten, bis auf das PTFE-Micropulver, liegen in Lösung vor.

Mit diesem Ansatz wurde eine Polyesterfolie (Hostaphan RN 25 der Fa. Hoechst AG, DIN A4) einseitig mittels eines 4 µm-Drahtrakels beschichtet und anschließend im Umlufttrockenschrank bei 120 °C ca. 2 min getrocknet.

Die beschichtete Folie zeigt einen Oberflächenwiderstand von 1.10⁶ Ohm (DIN 53482 mittels Federzungenelektrode).

Diese Folie wurde dann in einer Vakuum-Metallisierungsanlage der Fa. Leybold AG/Hanau auf der beschichteten Seite mit Aluminium bedampft. Vor der Bedampfung betrug die optische Dichte der beschichteten Polyesterfolie 0.1 bis 0.11 (gemessen mit einem Transmissionsdensitometer der Fa. Getag); durch die ca. 0.05 bis 0.07 µm dicke Aluminiumschicht erhöht sich die optische Dichte auf 2.3 bis 2.4.

Die Haftung der Metallschicht auf der Substratoberfläche wurde mittels Klebeband (nach ASTM D-3359; Tesafilm Nr. 104, Gitterschnittgerät Typ GS 30) bestimmt. Nach Abziehen des Klebebandes unter einem Abzugswinkel von 90° wurde ein vollständiges Ablösen der Metallschicht auf der Gitterschnittfläche festgestellt. Der Oberflächenwiderstand der auf der Polyesterfolie verbleibenden Beschichtung wurde nach Ablösen der Metallschicht zu 5·10⁶ Ohm bestimmt. Die optische Dichte betrug - wie bereits vor der Metallisierung - 0.1 bis 0.11. Die Meßergebnisse zeigen, daß eine für die Anwendungen bei der Transfermetallisierung erforderliche gute Haftung der antistatischen Beschichtung auf der Polyesterfolie und gleichzeitig eine ausreichend trennende Wirkung zur aufgedampften Metallschicht erzielt wurde.

### Beispiel 2

In 47.9 g NMP wurden 0.3 g elektrisch leitfähiges Polyethoxythiophen (aus Beispiel 1) und 1.7 g Hostaflon TFB X 7200 (lösliches Fluorpolymer der Hoechst AG) unter Zusatz von 0.1 g Edaplan LA 411 bei Raumteperatur gelöst (4 Stunden Horizontalschüttler wie Beispiel 1). Der Feststoffgehalt der Lösung betrug 4 % bei einem Mengenverhältnis Polyethoxythiophen: Hostaflon TFB X7200 von 15:85.

Nach Beschichten der Polyesterfolie (analog Beispiel 1, jedoch bei einer Trocknungstemperatur von 150 °C für 2 min. im Umlufttrockenschrank) wurde ein Oberflächenwiderstand von 2·10**⁶** Ohm und eine optische Dichte der beschichteten Folie von 0.09 bis 0.1 gemessen. Metallisierung und Haftungsprüfung wurden analog Beispiel 1 durchgeführt. Beim Tesafilmtest wurde eine vollständige Ablösung der Metallschicht erzielt; der Oberflächenwiderstand der Antistatika beschichtung nach Ablösen der Metallschicht betrug 5·10⁶ Ohm, die optische Dichte blieb konstant.

## Patentansprüche

1. Beschichtungsmittel für Kunststoffolien, enthaltend ein intrinsisch elektrisch leitfähiges Polymer und ein oder mehrere Additive, welche gegenüber einer auf die Kunststoffolie aufzubringenden Metallschicht eine Antihaftwirkung besitzen.

2. Beschichtungsmittel nach Anspruch 1, dadurch gekennzeichnet, daß es zusätzlich ein oder mehrere Bindemittel enthält, welches die Haftung der Beschichtung auf der Kunststoffolienoberfläche verbessern.

3. Beschichtungsmittel nach Anspruch 1, enthaltend 5 bis 90 Gew.-% des intrinsisch elektrisch leitfähigen Polymers und 1 bis 85 Gew.-% des oder der Additive mit Antihaftwirkung, jeweils bezogen auf das Trockengewicht des Beschichtungsmittels.

4. Beschichtungsmittel nach Anspruch 2, enthaltend 5 bis 90 Gew.-% des intrinsisch elektrisch leitfähigen Polymers, 1 bis 85 Gew.-% des oder der Additive mit Antihaftwirkung und 0 bis 90 Gew.-% des oder der Bindemittel, jeweils bezogen auf das Trockengewicht des Beschichtungsmittels.

5. Beschichtungsmittel nach einem oder mehreren der Ansprüche 1 bis 4, dadurch gekennzeichnet, daß das intrinsisch elektrisch leitfähige Polymer ein Polypyrrol, Polythiophen oder Polyanilin oder eine Mischung aus zwei oder mehreren dieser Substanzen ist.

6. Beschichtungsmittel nach einem oder mehreren der Ansprüche 1 bis 5, dadurch gekennzeichnet, daß die Kunststoffolie eine ein- oder mehrschichtige Polyesterfolie oder eine solche auf Basis eines α-Olefins ist.

7. Beschichtungsmittel nach Anspruch 6, dadurch gekennzeichnet, daß die Polyesterfolie eine Polyethylenterephthalatfolie und die Folie auf α-Olefinbasis eine Polypropylenfolie ist.

8. Beschichtungsmittel nach einem oder mehreren der Ansprüche 1 bis 7, dadurch gekennzeichnet, daß das intrinsisch elektrisch leitfähige Polymere ein Polyalkoxythiophen ist.

9. Beschichtungsmittel nach Anspruch 8, dadurch gekennzeichnet, daß das Polyalkoxythiophen sich aus Struktureinheiten der Formel 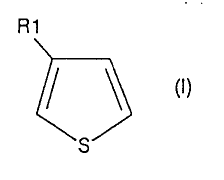 zusammensetzt, wobei
R¹ eine C₁-C₁₂-Alkoxygruppe bedeutet und wobei die Monomereinheiten in 2- und/oder 5-Stellung miteinander verbunden sind.

10. Beschichtungsmittel nach einem oder mehreren der Ansprüche 1 bis 9, dadurch gekennzeichnet, daß das intrinsisch elektrisch leitfähige Polymer in seiner oxidierten Form zur Kompensation der positiven Ladungen auf der Polymerkette eine entsprechende Anzahl von Anionen aufweist, die ausgewählt sind aus der Gruppe: BF₄⁻, PF₆⁻ SbF₆⁻, SbCl₆⁻, FeCl₄⁻, [Fe(CN-₆)]³⁻ und Kombinationen dieser Anionen.

11. Beschichtungsmittel nach einem oder mehreren der Ansprüche 1 bis 10, dadurch gekennzeichnet, daß das Bindemittel ein Lösungsmittel enthält, in dem die Bestandteile des Bindemittels gelöst, gequollen oder dispergiert sind.

12. Beschichtungsmittel nach einem oder mehreren der Ansprüche 8 bis 11, dadurch gekennzeichnet, daß das Polyalkoxythiophen in der oxidierten Form in einem dipolar aprotischen Lösungsmittel bei 25 °C vollständig löslich ist.

13. Beschichtungsmittel nach den Ansprüchen 11 oder 12, dadurch gekennzeichnet, daß das Beschichtungsmittel mindestens 0.1 g des intrinsisch elektrisch leitfähiges Polymers in 100 ml Lösemittel bei 25 °C enthält.

14. Beschichtungsmittel nach einem oder mehreren der Ansprüche 2 bis 13, dadurch gekennzeichnet, daß das Bindemittel ausgewählt wird aus einer oder mehreren Verbindungen aus der Gruppe: Polyvinylacetal, Polyvinylacetat, Polymaleinsäureanhydrid, Poly-N-vinylpyrrolidon, Poly-4-vinylpyrridin, Polymethylmethacrylat, Polyacrylat, Polyethylenmethacrylat, Polyacrylat, Polyacrolein, Polyformaldehyd, Polyethylenoxid, Polypropylenoxid, Celluloseacetat, Styrol-Acrylnitril-Copolymere, Polyacrylnitril, Polymethacrylnitril, Polyvinylchlorid, Polyvinylidenfluorid, Poly-N-vinylcarbazol, Polyvinylacetamid, Polyacrylsäureanhydrid, Polyethylencarbonat, Poly-ε-caprolactam, Polycarbonat, Polymethylmethacrylat, Polyethylmethacrylat, Polyethylenoxid, Polyester, Polyethylen, Polypropylen oder generell Polyolefine, Poly-ε-caprolactam, Polyurethan, Polyvinylalkohol sowie beliebige Copolymere hieraus.

15. Beschichtungsmittel nach einem oder mehreren der Ansprüche 1 bis 14, dadurch gekennzeichnet, daß das Additiv, welches gegenüber einer auf die Kunststoffolie aufzubringenden Metallschicht eine Antihaftwirkung besitzt, ausgewählt wird aus einer oder mehreren Verbindungen aus der Gruppe: Trennharze aus fluorhaltigen und/oder fluormodifizierten Polymeren, Silikonharze, Silikonöle, Polysiloxane, Fettsäuren, Metallsalze von Fettsäuren, Alkylamine, Fettsäureester, Fettsäureamide und Sulfonate.

16. Beschichtungsmittel nach Anspruch 15, dadurch gekennzeichnet, daß das fluorhaltige und/oder fluormodifizierte Polymere ein solches mit einem mittleren Teilchendurchmesser von kleiner 15 µm ist.

17. Beschichtungsmittel nach einem oder mehreren der Ansprüche 1 bis 16, dadurch gekennzeichnet, daß das Beschichtungsmittel ein Lösungsmittel und/oder Quellmittel und/oder Dispergiermittel enthält, ausgewählt aus den Verbindungen der Gruppe: Acetonitril, N-Methylpyrrolidon, N,N-Dimethylformamid, Aceton, Methylenchlorid, Tetrahydrofuran, Ethanol und Wasser.

18. Verfahren zur Beschichtung einer Kunststoffolie, dadurch gekennzeichnet, daß die Kunststoffolie mit einem Beschichtungsmittel gemäß einem der Ansprüche 1 bis 17 beschichtet wird.

19. Verfahren nach Anspruch 18, dadurch gekennzeichnet, daß der Feststoffgehalt in dem Beschichtungsmittel zwischen 1 und 20 Gew.-% liegt.

20. Verfahren nach Anspruch 18 oder 19, dadurch gekennzeichnet, daß die Beschichtung in einem Naßantragverfahren durch Flexodruck, Tiefdruck, Glattwalzenantrag, Tauchverfahren oder Spritzverfahren erfolgt.

21. Verfahren nach einem oder mehreren der Ansprüche 18 bis 20, dadurch gekennzeichnet, daß die Beschichtung ein- oder beidseitig erfolgt.

22. Verfahren nach einem oder mehreren der Ansprüche 18 bis 21, dadurch gekennzeichnet, daß die Kunststoffolie im Anschluß an die Beschichtung mittels Warmluft und/oder Wärmestrahlen getrocknet wird.

23. Verfahren nach einem der Ansprüche 18 bis 22, dadurch gekennzeichnet, daß die Kunststoffolie eine Polyethylenterephthalat- oder Polypropylenfolie ist.

24. Beschichtete Kunststoffolie, erhältlich nach einem oder mehreren der Verfahren gemäß den Ansprüchen 18 bis 23.

25. Verwendung des Beschichtungsmittels gemäß den Ansprüchen 1 bis 17 als ein- oder beidseitiges Beschichtungsmittel für Kunststoffolien für die Transfermetallisierung.

26. Verwendung des Beschichtungsmittels gemäß den Ansprüchen 1 bis 17 als ein- oder beidseitiges Beschichtungsmittel für Prägefolien.

27. Verwendung der Kunststoffolie gemäß Anspruch 24 für die Transfermetallisierung oder als Prägefolie.

28. Metallisierte Kunststoffolie, bestehend aus einer beschichteten Kunststoffolie gemäß Anspruch 24 und einer auf mindestens einer ihrer Oberflächen aufgebrachten Metallschicht.

29. Metallisierte Kunststoffolie nach Anspruch 28, dadurch gekennzeichnet, daß die Metallschicht aus Aluminium besteht.
